# FASCICULE DE BREVET EUROPEEN

(11) **EP 2 473 885 B1**
(45) Date de publication et mention de la délivrance du brevet: **29.05.2013**
(21) Numéro de dépôt: 10760896.0
(22) Date de dépôt: 01.09.2010
(51) Int. Cl.: G04F 5/14

(54) **DISPOSITIF POUR HORLOGE ATOMIQUE**
VORRICHTUNG FÜR ATOMUHR
DEVICE FOR ATOMIC CLOCK

(30) Priorité: 04.09.2009 EP 09405149; 07.05.2010 CH 703102010
(43) Date de publication de la demande: 11.07.2012
(73) Titulaire: CSEM Centre Suisse d'Electronique et de Microtechnique SA, 2002 Neuchâtel (CH)
(72) Inventeur: LECOMTE, Steve, CH-1233 Bernex (CH); HAESLER, Jacques, CH-3280 Murten (CH)
(74) Mandataire: Moinas & Savoye SA
(86) Numéro de dépôt international: PCT/CH2010/000214
(87) Numéro de publication internationale: WO 2011/026251

(56) Documents cités:
- US-A1- 2005 264 818
- US-A1- 2009 128 820
- BENDELLI, G. AND DONATI, S.: "Optical Isolators for telecommunications: review and current trends", EUROPEAN TRANSACTIONS ON TELECOMMUNICATIONS AND RELATED TECHNOLOGIES, vol. 3, no. 4, juillet 1992 (1992-07), - août 1992 (1992-08), pages 373-380, XP002617056,

## Description

La présente invention concerne le domaine des horloges atomiques.

### Etat de l'Art

Les horloges atomiques miniatures (volume d'un cm³ ou inférieur), à basse consommation électrique (inférieure au Watt) et qui permettent des applications portables sont des dispositifs rendus possibles par la combinaison des principes physiques CPT (piégeage cohérent de population) ou Raman avec une architecture d'horloge atomique basée sur une cellule d'absorption à gaz. Ces deux principes physiques ne nécessitent pas de cavité microonde pour interroger les atomes de référence (typiquement Rubidium ou Césium) et éliminent ainsi la contrainte de volume associée aux horloges atomiques traditionnelles de type cellule. La partie physique de l'horloge, qui est constituée de la source lumineuse, des éléments optiques, de la cellule à gaz, du photodétecteur et de toutes les fonctions telles que chauffage et génération de champ magnétique, va faire l'objet des considérations qui suivent. L'implémentation de technologies telles que les lasers de type semi-conducteur à émission de surface et cavité verticale (vertical cavity surface-emitting laser, VCSEL), les techniques de microfabrication pour les cellules à gaz et d'encapsulation sous vide ont permis de réduire massivement le volume et la consommation électrique de ces horloges atomiques. Les lasers VCSEL offrent la possibilité de combiner la fonction de pompage optique et l'interrogation microonde des atomes de référence. Ce type de laser offre les avantages suivants : modulation du courant d'injection possible jusqu'à plusieurs gigahertz, basse consommation, longueur d'onde compatible avec les atomes standards de référence (Rubidium ou Césium), excellente durée de vie, fonctionnement à haute température, bas coût et puissance optique idéalement adaptée. Les technologies de microstructuration du silicium couplées aux procédés de collage/soudage d'un substrat en verre (typiquement pyrex ou quartz) sur un substrat en silicium permettent de réaliser des cellules à gaz de dimensions beaucoup plus petites que ce qu'il est possible de réaliser avec la technique traditionnelle de soufflage et formage de tube en verre. La réduction des dimensions de la cellule à gaz est également accompagnée par une diminution de la consommation nécessaire pour chauffer la cellule à gaz.

Différents arrangements de la partie physique d'une telle horloge ont été réalisés. La majorité des arrangements sont basés sur un passage unique du faisceau laser au travers de la cellule (voir S. Knappe, MEMS atomic clocks, Book chapter in Comprehensive Microsystems, vol. 3, p. 571 (2008), Ed. Elsevier), d'autres tirant profit de cellules à gaz comportant des miroirs à l'intérieur de la cellule ou encore permettant un double passage du faisceau laser au travers de la cellule (voir documents US7064835 et EP0550240). Les arrangements avec double passage de la lumière au travers de la cellule ont l'avantage de doubler la longueur optique effective de la cellule et donc d'améliorer les performances de l'horloge atomique (en termes de consommation électrique et/ou de stabilité de fréquence). Néanmoins, ces arrangements double passage n'ont pas été implémentés pour des raisons d'instabilité du dispositif et en particulier à cause de perturbations du laser provoquées par la lumière rétro-réfléchie par les miroirs sur le laser.

US 2009/0128820 décrit une horloge atomique selon le préambule de la revendication 1.

### Brève description de l'invention

La présente invention vise donc à proposer un dispositif pour horloge atomique permettant un double passage dans la cellule sans les inconvénients de l'état de la technique.

Ce but est atteint par un dispositif pour horloge atomique tel que défini dans la revendication 1.

### Brève description des figures

L'invention sera mieux comprise grâce à la description détaillée qui va suivre en se référant aux dessins annexés dans lesquels :
Figure 1a : Schéma de principe de l'horloge CPT
Figure 1b : Schéma de principe de l'oscillateur Raman
Figure 2 : Schéma simplifié de l'invention
Figure 3: Présentation schématique éclatée du dispositif de l'invention avec géométrie à angle droit et à double passage
Figure 4: Présentation schématique de la conception du dispositif de l'invention avec géométrie à angle droit et double passage
Figure 5: Présentation schématique éclatée du dispositif de l'invention avec géométrie droite et à double passage
Figure 6a : Présentation schématique de la conception du dispositif de l'invention avec géométrie droite et double passage, particulièrement adaptée à l'implémentation du concept de l'horloge atomique CPT
Figure 6b : Présentation schématique de la conception du dispositif de l'invention avec géométrie droite et double passage, particulièrement adaptée à l'implémentation du concept de l'oscillateur Raman
Figure 7: Présentation schématique de la conception du dispositif de l'invention avec géométrie à angle droit et double passage, particulièrement adaptée à l'implémentation du concept de l'oscillateur Raman

### Description détaillée

La figure la illustre le schéma de principe de l'horloge atomique CPT comprenant une diode laser **102**, une lame λ/4 (ou lame quart d'onde) **105**, une cellule à gaz (atomique) **106**, un champ magnétique B, un premier photodétecteur **108**, une électronique de contrôle (A) et un oscillateur micro-onde (C). Le faisceau laser ayant traversé la cellule à gaz **106** est capté par le premier photodétecteur **108** et est utilisé par l'électronique de contrôle pour stabiliser la fréquence du laser (B) et la fréquence de l'oscillateur microonde (C).

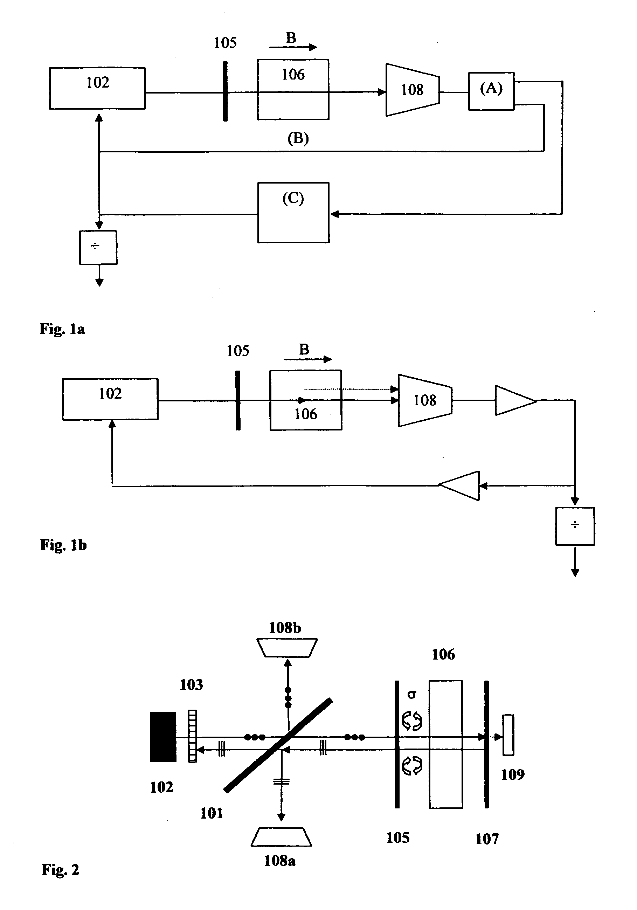

La figure 1b illustre le schéma de principe d'un oscillateur Raman en boucle fermée comprenant une diode laser **102**, une lame λ/4 (ou lame quart d'onde) **105**, une cellule à gaz (atomique) **106**, un champ magnétique B, un premier photodétecteur **108**, un diviseur de fréquence microonde, et un amplificateur RF. Le faisceau laser émis par la diode laser **102** subit dans la cellule à gaz **106** une interaction lumière-atome qui génère un faisceau complémentaire appelé faisceau Raman. Les deux faisceaux de lumière sont captés par le premier photodétecteur **108** et le battement de fréquences de ces deux faisceaux est amplifié et utilisé comme rétroaction sur le laser pour fermer la boucle microonde de l'oscillateur Raman.

La figure 2 illustre le principe de base de l'invention. Dans cette figure, la polarisation du faisceau est symbolisée par des traits lorsque celle-ci est perpendiculaire à la polarisation du faisceau émis par le laser et par des cercles pleins lorsqu'elle y est parallèle. La polarisation circulaire est notée « σ ». La source laser **102** produit un faisceau laser qui est en général polarisé linéairement et qui est dirigé vers le polariseur **103**, dont l'axe de transmission est orienté de manière à laisser passer le faisceau laser en partie ou en totalité, puis vers le séparateur **101** dont le pourcentage de séparation est prédéfini. Une partie du faisceau est ainsi réfléchie vers le photodétecteur **108b**. Le séparateur transmet l'autre partie du faisceau vers une lame quart d'onde **105**. Le rôle de la lame **105** est de changer la polarisation linéaire du faisceau laser vers une polarisation circulaire. En effet, l'interaction entre la lumière et les atomes de la cellule à gaz **106** est optimale lorsqu'elle est réalisée avec un faisceau de polarisation circulaire. Une partie du faisceau sortant de la cellule à gaz **106** est ensuite réfléchi par un miroir **107**, ce qui inverse le sens de sa polarisation circulaire, et traverse ainsi une seconde fois la cellule à gaz **106**. En sortant de la cellule à gaz **106**, le faisceau atteint la lame quart d'onde **105**. Selon le pourcentage de séparation prédéfini du séparateur **101**, ce faisceau est en partie dévié et atteint le photodétecteur **108a**. Une autre partie de ce faisceau est transmise par le séparateur **101** et est atténuée par le polariseur **103** car sa polarisation est perpendiculaire à celle de l'axe de transmission du polariseur **103**, la source laser **102** étant ainsi protégée des rétro-réflexions. Une faible partie du faisceau ayant traversé la cellule à gaz **106** est transmise par le miroir **107** et captée par le photodétecteur **109**.

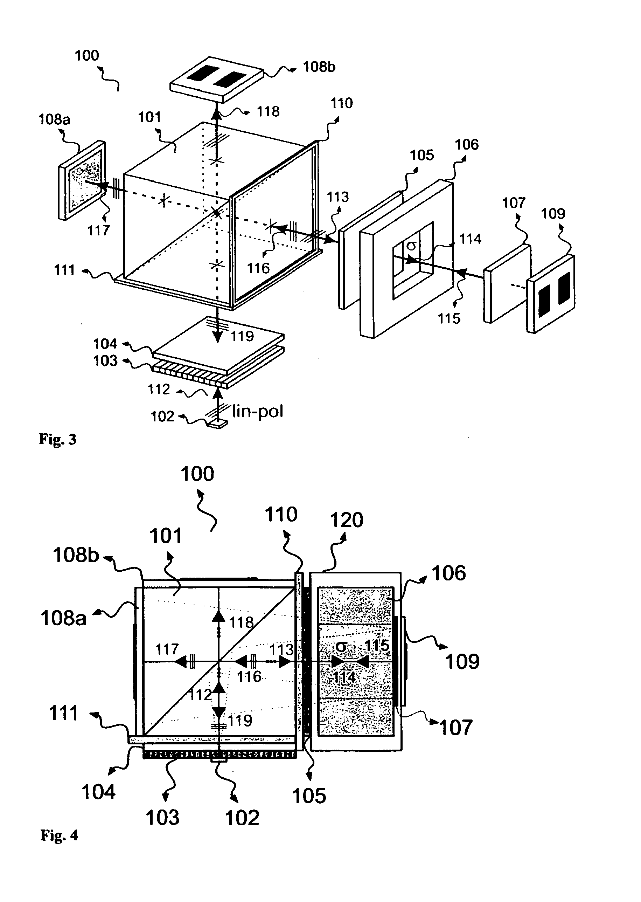

Un exemple de réalisation plus complet est illustré à la figure 3 (schéma éclaté). Le séparateur **101** est réalisé sous la forme d'un cube séparateur. Ce cube permet d'implémenter une double traversée de la cellule à gaz **106** qui multiplie par deux l'interaction entre la lumière du laser et le milieu atomique. On obtient un meilleur signal atomique et ainsi une meilleure stabilité de la fréquence de l'horloge atomique.

Sur la figure 3, l'ensemble optique est basé sur un cube miniature **101** dont les côtés sont de préférence inférieurs ou égaux à 1 mm, le cube **101** faisant office de séparateur. Selon un mode standard, le volume du cube est de typiquement 1mm³.

Le faisceau de lumière de la diode laser **102** arrive sur l'un des côtés du cube **101**. Selon un mode de réalisation, la diode laser est de type semi-conducteur à cavité verticale et à émission de surface (VCSEL) émettant un faisceau divergeant de lumière à 795 nm. Dans d'autres modes de réalisation, d'autres types de diodes laser ayant des longueurs d'ondes variant typiquement de 780 nm à 894 nm peuvent être utilisés pour une cellule à gaz contenant du Rubidium ou du Césium. Ce choix est dicté par la composition atomique de la cellule à gaz. Selon un mode de réalisation, une lentille de collimation peut être ajoutée devant la diode laser pour produire un faisceau laser non-divergeant.

Selon un mode standard, la lumière produite **112** par le laser a une polarisation linéaire, passe par le polariseur **103** et est atténuée par un filtre neutre absorbant **104**. Un type différent de filtre peut être utilisé dans d'autres modes de réalisation. La présence de ce filtre n'est pas nécessaire à l'invention. Une lame quart d'onde **105** est placée en sortie de cube contre la face d'où sort le faisceau laser dévié par le séparateur **101**, soit à angle droit du faisceau incident au cube. L'axe rapide de la lame quart d'onde **105** est orienté de telle sorte que la polarisation linéaire incidente **113** est modifiée vers une polarisation circulaire **114** selon un premier sens de rotation. Dans d'autres modes de réalisation, la lame quart d'onde **105** est orientée de telle sorte que la polarisation linéaire incidente **113** est modifiée vers une polarisation circulaire selon un sens de rotation inverse au premier. Le rayon laser de polarisation circulaire **114** traverse la cellule à gaz **106**. Selon un mode standard, la cellule à gaz est réalisée en verre-silicium-verre par des techniques MEMS (microsystème électromécanique) avec un volume intérieur de typiquement 1 mm³ et remplie avec un milieu absorbant de type vapeur atomique de métal alcalin (Rubidium ou Césium), et un mélange de gaz tampon. Selon un mode standard, la cellule à gaz est remplie avec du Rubidium-87 et un mélange d'azote et d'argon comme gaz tampon. Dans d'autres formes de réalisations, d'autres types de cellules peuvent être remplies avec des gaz intérieurs différents. Selon un mode particulier, une cellule miniature cylindrique peut être utilisée. Selon un autre mode particulier, la cellule à gaz peut être intégrée dans le cube **101**. La cellule **106** peut être remplie avec d'autres types de vapeur métallique alcaline (rubidium-85, rubidium naturel, césium-133 par exemple) et d'autres types de gaz tampon (Xe, Ne par exemple).

### Mode de réalisation de l'horloge CPT

La figure 4 illustre la conception du dispositif pour l'horloge CPT. Selon un mode de réalisation standard (boîtier à angle droit), le pourcentage de séparation du séparateur **101** est prédéfini de manière à avoir une transmission majoritaire et une réflexion minoritaire d'au moins 50% et de moins de 50%, préférentiellement d'au moins 75% et de moins de 25%, idéalement d'environ 90% et 10% respectivement.

Après son interaction avec les atomes de la vapeur de métal alcalin, le faisceau de lumière **114** polarisé circulairement est majoritairement réfléchi par un miroir **107**. Dans un mode de réalisation CPT standard, la fenêtre de sortie de la cellule à gaz **106** est recouverte de métal (argent ou or, par exemple) pour jouer le rôle de réflecteur. Dans un autre mode de réalisation, le revêtement de la fenêtre de sortie de la cellule à gaz peut être un miroir diélectrique. La transmission du réflecteur **107** peut être choisie de manière à ce qu'une faible partie de la lumière soit transmise vers le photodétecteur **109**. La lumière rétro-réfléchie **115** passe à travers et interagit une seconde fois avec le milieu atomique (double passage). En sortie de cellule, le faisceau traverse la lame quart d'onde **105** qui transforme sa polarisation circulaire en polarisation linéaire **116**, perpendiculaire à l'axe de transmission du polariseur **103**, et est majoritairement transmis par le cube séparateur miniature **101**. Ce faisceau de lumière transmis **117** atteint le photodétecteur **108a** qui enregistre le spectre d'absorption et plus spécifiquement la diminution d'absorption due au processus de piégeage cohérent de population (CPT). Dans un mode de réalisation CPT standard, le photodétecteur **108a** est un photodétecteur de type silicium. Dans d'autres modes de réalisation CPT, différents types de photodétecteurs peuvent être utilisés. La partie minoritaire **119** du faisceau **116** dévié par le séparateur **101** est atténuée par le polariseur **103** et ne perturbe ainsi pas le laser. Dans un mode de réalisation particulier, le photodétecteur **108a** peut être déplacé et peut remplacer le miroir **107**. Dans ce cas particulier, une version à passage unique du modèle **100** serait créée. Le second photodétecteur **108b** enregistre le faisceau de lumière **118** transmis initialement par le cube séparateur miniature **101**. De cette manière, la puissance de sortie de la source laser **102** peut être mesurée et réglée par une boucle d'asservissement dédiée. Les diaphragmes **110** et **111** sont utilisés pour éviter qu'une lumière indésirable n'atteigne les photodétecteurs si la taille du faisceau laser est supérieure aux dimensions des faces du cube séparateur miniature **101**. La lumière enregistrée par le photodétecteur **109** situé après le miroir **107** peut être utilisée pour différents types d'asservissement tels que fréquence du laser ou température de la cellule.

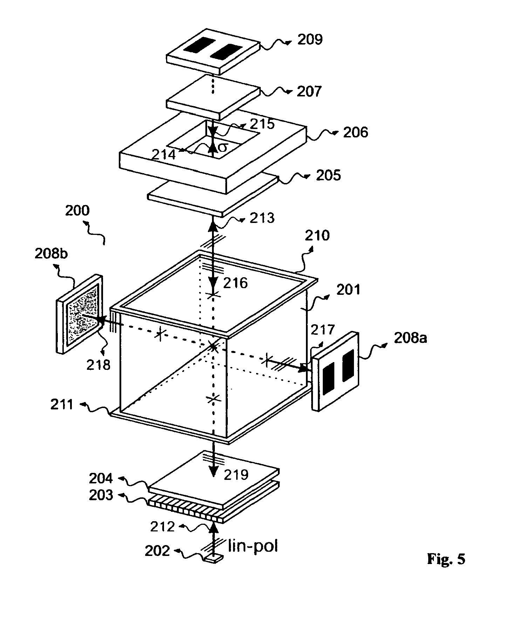

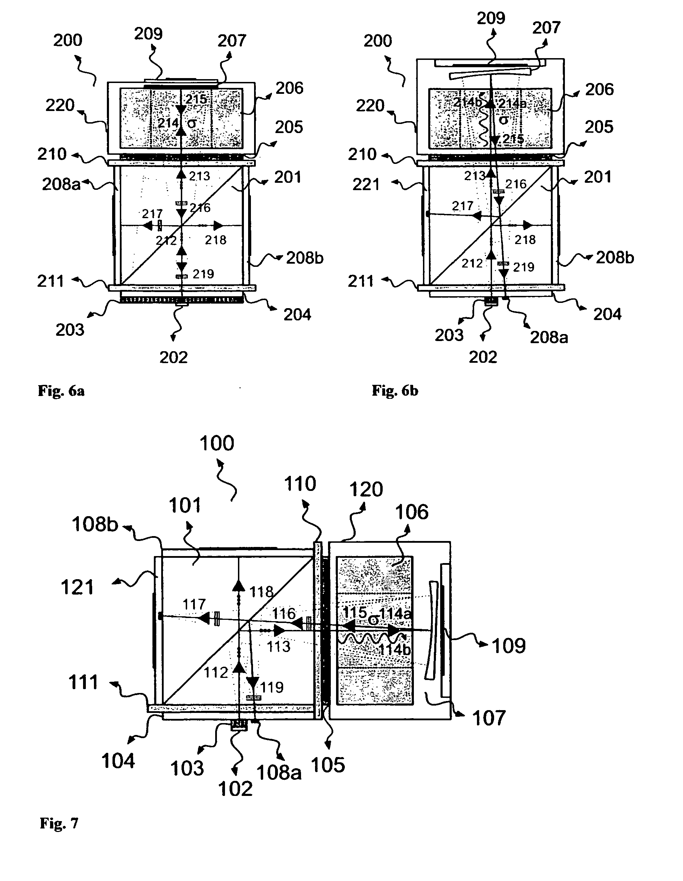

Sur la figure 6a et selon un mode de réalisation à géométrie droite (schéma éclaté du boîtier à géométrie droite illustré sur la Figure 5), le pourcentage de séparation du cube séparateur est prédéfini de manière inverse à celle décrite ci-dessus (boîtier à angle droit), à savoir une transmission minoritaire et une réflexion majoritaire de moins de 50% et d'au moins 50%, préférentiellement de moins de 25% et d'au moins 75%, idéalement d'environ 10% et 90% respectivement. La conception à double passage optique droit ainsi obtenue **200** (le codage numérique commence à **200** pour la conception **200**) est très similaire à la conception à angle droit et double passage **100** (voir Figure 4). Le rôle du séparateur **201** est ainsi inversé afin que la partie minoritaire du faisceau provenant de la source laser **102** soit transmise plutôt que déviée. Pour sa part, le faisceau rétro-réfléchi **216** est alors majoritairement dévié vers le photodétecteur **208a**. La différence principale dans l'arrangement des différents éléments comparée à la conception **100** réside dans la position de l'entité cellule « cellule à gaz **206**, lame quart d'onde **205**, miroir **207** et photodétecteur **209** ». Dans le modèle **200** de la figure 6, l'entité cellule à gaz est placée au dessus du cube séparateur **201** et est donc située vis-à-vis du laser **102**. Le photodétecteur **208b** est placé à angle droit, où le faisceau de lumière émis par le laser est réfléchi par le cube séparateur **201** et est utilisé pour la mesure de la puissance laser. A part ces différences, le principe de fonctionnement de la conception **200** est le même que pour le modèle **100**.

### Mode de réalisation de l'oscillateur Raman

La figure 7 illustre un mode de réalisation particulièrement adapté au concept de l'oscillateur Raman. Selon un mode de réalisation standard (boîtier à angle droit), le pourcentage de séparation du séparateur **101** est prédéfini de manière à avoir une transmission minoritaire et une réflexion majoritaire de moins de 20% et d'au moins 80%, préférentiellement de moins de 10% et d'au moins 90%, plus préférentiellement égal ou inférieur à 2% et égal ou supérieur à 98%, idéalement d'environ 1% et 99% respectivement. Après son interaction avec les atomes de la vapeur de métal alcalin, le faisceau de lumière incident **114a** et le faisceau de lumière généré par la diffusion Raman stimulée (appelé faisceau Raman) **114b** sont réfléchis par un miroir **107**. Dans un mode de réalisation Raman standard, le miroir **107** est réfléchissant (couche réfléchissante d'or ou d'argent ou miroir de Bragg fait de couches diélectriques), il est incliné (typiquement de 2 à 3 degrés) et est concave avec une longueur focale choisie pour focaliser les faisceaux de lumière rétro-réfléchis **115** (faisceaux incident et Raman) sur le photodétecteur **108a**. Le miroir **107** a une transmission typique de quelques pourcents. Ces pourcents de lumière transmise atteignent la surface du photodétecteur **109** utilisé pour mesurer le spectre d'absorption et pour stabiliser la fréquence optique du laser. Dans une réalisation Raman différente, la fenêtre de sortie de la cellule à gaz **106** est concave, revêtue d'argent (ou d'un autre métal, comme par exemple l'or ou même un miroir de Bragg fait de couches diélectriques) et joue le rôle de réflecteur. Dans une autre réalisation Raman, le miroir est plan et une lentille est utilisée pour focaliser le faisceau sur le photodétecteur **108a**. Si l'intensité du faisceau Raman est suffisante, il est également possible de se passer de moyen de focalisation.

Les faisceaux de lumière rétro-réfléchis **115** (incident et Raman) passent à travers et interagissent une seconde fois avec le milieu atomique (double passage). La lame quart d'onde **105** transforme ces faisceaux de lumière polarisés circulairement en faisceaux de lumière de polarisation linéaire. Ces faisceaux de lumière sont majoritairement dévié **119** (incident et Raman) et atteignent le premier photodétecteur **108a** qui enregistre le battement de fréquences entre le faisceau incident et le faisceau Raman. Dans un mode de réalisation Raman standard, le premier photodétecteur **108a** est un photodétecteur de type semi-conducteur à grande vitesse (fait de Si, GaAs ou InGaAs) qui est positionné au foyer du miroir concave **107**. Dans d'autres modes de réalisation Raman, différents types de photodétecteurs à grande vitesse peuvent être utilisés. Le second photodétecteur **108b** enregistre la lumière **118** provenant directement du laser **102** et transmise initialement par le cube séparateur miniature **101**. De cette manière, la puissance de sortie de la source laser **102** peut être mesurée et réglée par une boucle d'asservissement dédiée. Le photodétecteur **121** enregistre le faisceau rétro-réfléchi **117** transmis par le séparateur **101**. Les diaphragmes **110** et **111** sont utilisés pour éviter qu'une lumière indésirable n'atteigne les photodétecteurs si leurs dimensions sont supérieures à celles du cube séparateur miniature **101**.

La figure 6b illustre la représentation schématique du boîtier à géométrie droite **200** à double passage du mode de réalisation Raman. Toutes les références numériques correspondent au modèle **100** du mode de réalisation Raman et commencent par **"2"** au lieu de **"1"**.

Avantages de la conception à double passage avec polariseur :
Comme mentionné ci-dessus, les avantages de la présente invention résident dans l'utilisation d'un cube central (cube séparateur) dans une conception à double passage. Pour un chemin d'absorption identique, la conception à double passage permet l'utilisation d'un dispositif plus compact comparé à la conception à un seul passage. Globalement, la conception à double passage avec un cube séparateur central offre une option compacte, robuste et très polyvalente avec beaucoup d'avantages par rapport aux conceptions connues.

La polyvalence de la présente conception est due aux différents rôles joués par le cube séparateur central. Ce dernier joue le rôle d'un ancrage robuste et stable qui simplifie la conception mécanique. Le cube séparateur central joue le rôle d'un isolant thermique en évitant aux photodétecteurs d'être chauffés par la cellule à gaz ou la diode laser, tous deux chauffés à une température d'environ 80°C. Associé au polariseur et à la lame quart d'onde, l'ensemble joue le rôle d'un isolateur optique et d'un filtre. La lumière qui entre dans la lame quart d'onde est parfaitement polarisée linéairement, ce qui permet une polarisation circulaire unique et ainsi un rendement d'interaction lumière-atomes optimal. Après une double interaction avec le milieu atomique, le faisceau de lumière sortant est filtré de manière à ce que la majeure partie de la lumière atteigne le photodétecteur. La partie du faisceau qui est rétro-réfléchie en direction de la diode laser est bloquée par le polariseur, ce qui évite de perturber l'émission du faisceau laser et permet la réalisation pratique d'un dispositif à double passage.

Cette isolation thermique permet également un contrôle de température séparé et sans interférence de la cellule à gaz et de la diode laser. Enfin, la conception à cube séparateur central avec deux photodétecteurs permet de mesurer simultanément le signal d'horloge et la puissance de sortie de la diode laser. Dans d'autres conceptions, la mesure de puissance laser et les mesures CPT sont effectuées au moyen d'un seul photodétecteur, des conceptions dans lesquelles les influences de la température de la cellule à gaz et la puissance de sortie intrinsèque de la diode laser sur l'amplitude du signal du photodétecteur ne peuvent pas être différentiées.

## Revendications

1. Dispositif pour horloge atomique comprenant une source laser (102) générant un faisceau laser, un séparateur (101) permettant de dévier et de laisser passer une partie du faisceau laser selon un pourcentage prédéfini, une lame quart d'onde (105) modifiant la polarisation linéaire du faisceau laser en une polarisation circulaire et inversement, une cellule à gaz placée sur le faisceau laser de polarisation circulaire, un miroir (107) renvoyant le faisceau laser vers la cellule à gaz (106), et un premier photodétecteur (108a), le séparateur (101) étant placé entre la source laser (102) et le miroir (107), la lame quart d'onde (105) étant placée entre le séparateur (101) et le miroir (107), la cellule à gaz (106) étant placée entre la lame quart d'onde (105) et le miroir (107), de telle sorte que la polarisation du faisceau provenant de la source laser (102) via le séparateur (101) et arrivant sur la lame quart d'onde (105) est linéaire selon le premier angle et est modifiée par la lame quart d'onde (105) en polarisation circulaire, et ainsi que la polarisation circulaire du faisceau réfléchi par le miroir (107) et traversant une seconde fois la cellule à gaz (106) est modifiée en polarisation linéaire selon le second angle par la lame quart d'onde (105), le séparateur (101) acheminant une partie du faisceau rétro-réfléchi vers le premier photodétecteur (108a), **caractérisé en ce que** le dispositif comporte de plus un polariseur (103) placé entre la sortie du faisceau laser et le séparateur afin de protéger la source laser des rétro-réflexions provenant des différents éléments optiques composant le dispositif, **en ce qu'**il comprend un second photodétecteur (108b) placé après le séparateur de telle sorte qu'une partie du faisceau laser atteigne ledit second photodétecteur (108b) sans avoir traversé la cellule à gaz (106).

2. Dispositif selon la revendication 1, **caractérisé en ce qu'**il comprend un troisième photodétecteur (109), placé derrière le miroir (107), ledit miroir étant semi-transparent et laissant passer une partie du faisceau laser, ledit troisième-photodétecteur (109) servant à l'asservissement en fréquence optique du laser et/ou à l'asservissement de la température de la cellule (106).

3. Dispositif selon l'une des revendications 1 et 2, **caractérisé en ce qu'**il comprend un diaphragme (110) placé entre le séparateur et la cellule à gaz (106), ce diaphragme réduisant la taille du faisceau laser.

4. Dispositif selon l'une des revendications 1 à 3, **caractérisé en ce qu'**il comprend un deuxième diaphragme (111) placé entre le séparateur et la cellule à gaz (106), ce diaphragme réduisant la taille du faisceau laser.

## Patentansprüche

1. Vorrichtung für eine Atomuhr mit einer einen Laserstrahl erzeugenden Laserquelle (102), mit einem Strahlteiler (101), der entsprechend einem vorbestimmten Anteil ein Ablenken und ein Durchlassen eines Teiles des Laserstrahles bewirkt, mit einer λ/4-Platte (105), die die lineare Polarisation des Laserstrahles in eine zirkulare Polarisation und umgekehrt ändert, mit einer Gaszelle, die zwischen dem Laserstrahl mit zirkularer Polarisation angeordnet ist, mit einem Spiegel (107), der den Laserstrahl in Richtung der Gaszelle (106) lenkt, und mit einem ersten Photodetektor (1 08a), wobei der Strahlteiler (101) zwischen der Laserquelle (102) und dem Spiegel (107) angeordnet ist, wobei die λ/4-Platte (105) zwischen dem Strahlteiler (101) und dem Spiegel (107) angeordnet ist, wobei die Gaszelle (106) zwischen der λ/4-Platte (105) und dem Spiegel (107) angeordnet ist, derart, dass die Polarisation des Strahles, der über den Strahlteiler (101) aus der Laserquelle (102) stammt und über die λ/4-Platte (105) eintrifft, in Richtung des ersten Winkels linear und durch die λ/4-Platte (105) in eine zirkulare Polarisation modifiziert ist und dass entsprechend die zirkulare Polarisation des Strahles, der durch den Spiegel (107) reflektiert ist und die Gaszelle (106) zum zweiten Mal durchläuft, durch die λ/4-Platte (105) in eine lineare Polarisation in Richtung des zweiten Winkels verändert ist, wobei der Strahlteiler (101) einen Teil des rückgeworfenen Strahles auf den ersten Photodetektor (108a) wirft, **dadurch gekennzeichnet, dass** die Vorrichtung weiterhin über einen Polarisator (103) verfügt, der zwischen dem Austritt des Laserstrahles und dem Strahlteiler angeordnet ist, um die Laserquelle vor Rückreflexionen zu schützen, die von verschiedenen die Vorrichtung bildenden optischen Elementen stammen, und dass sie weiterhin einen zweiten Photodetektor (108b) aufweist, der derart nach dem Strahlteiler angeordnet ist, dass ein Teil des Laserstrahles ohne Passieren der Gaszelle (106) den zweiten Photodetektor (1 08b) beaufschlagt.

2. Vorrichtung nach Anspruch 1, **dadurch gekennzeichnet, dass** sie weiterhin über einen dritten Photodetektor (109) verfügt, der hinter dem Spiegel (107) angeordnet ist, wobei der Spiegel halbdurchlässig ist und einen Teil des Laserstrahles passieren lässt, wobei der dritte Photodetektor (109) zum Beeinflussen der optischen Frequenz des Lasers und/oder zum Beeinflussen der Temperatur der Zelle (106) dient.

3. Vorrichtung nach einem der Ansprüche 1 oder 2, **dadurch gekennzeichnet, dass** sie weiterhin über eine Blende (110) verfügt, die zwischen dem Strahlteiler und der Gaszelle (106) angeordnet ist, wobei die Blende die Strahlweite des Laserstrahles verringert.

4. Vorrichtung nach einem der Ansprüche 1 bis 3, **dadurch gekennzeichnet, dass** sie weiterhin über eine zweite Blende (111) verfügt, die zwischen dem Strahlteiler und der Gaszelle (106) angeordnet ist, wobei die Blende die Strahlweite des Laserstrahles verringert.

## Claims

1. A device for an atomic clock comprising a laser source (102) generating a laser beam, a splitter (101) for deflecting and allowing a portion of the laser beam to pass according to a predefined percentage, a quarter-wave plate (105) modifying the linear polarization of the laser beam into a circular polarization and vice versa, a gas cell placed on the laser beam of circular polarization, a mirror (107) sending the laser beam back toward the gas cell (106), and a first photodetector (108a), the splitter (101) being placed between the laser source (102) and the mirror (107), the quarter-wave plate (105) being placed between the splitter (101) and the mirror (107), the gas cell (106) being placed between the quarter-wave plate (105) and the mirror (107), in such a way that the polarization of the beam originating from the laser source (102) via the splitter (101) and arriving on the quarter-wave plate (105) is linear according to the first angle and is modified by the quarter-wave plate (105) into circular polarization, and so that the circular polarization of the beam reflected by the mirror (107) and passing a second time through the gas cell (106) is modified into linear polarization according to the second angle by the quarter-wave plate (105), the splitter (101) directing a portion of the back-reflected beam toward the first photodetector (108a), **characterized in that** the device also comprises a polarizer (103) placed between the output of the laser beam and the splitter in order to protect the laser source from the back-reflections originating from the various optical elements that make up the device and **in that** it comprises a second photodetector (108b) placed after the splitter in such a way that a portion of the laser beam reaches said second photodetector (108b) without having passed through the gas cell (106).

2. The device as claimed in claim 1, **characterized in that** it comprises a third photodetector (109), placed behind the mirror (107), said mirror being semi-transparent and allowing a portion of the laser beam to pass, said third photodetector (109) being used to control the optical frequency of the laser and/or to control the temperature of the cell (106).

3. The device as claimed in claim 1 and 2, **characterized in that** it comprises a diaphragm (110) placed between the splitter and the gas cell (106), this diaphragm reducing the size of the laser beam.

4. The device as claimed in claim 1 to 3, **characterized in that** it comprises a second diaphragm (111) placed between the splitter and the gas cell (106), this diaphragm reducing the size of the laser beam.
